# EUROPEAN PATENT SPECIFICATION

(11) **EP 4 398 286 B1**
(45) Date of publication and mention of the grant of the patent: **22.04.2026**
(21) Application number: 23187581.6
(22) Date of filing: 25.07.2023
(51) Int. Cl.: H01L 21/28, H10D 64/01, H10B 43/27, H10B 43/30, G11C 11/22, H10B 51/20, H10D 64/68

(54) **VERTICAL NAND FLASH MEMORY DEVICE**
VERTIKALE NAND-FLASH-SPEICHERVORRICHTUNG
DISPOSITIF DE MÉMOIRE FLASH NAND VERTICALE

(30) Priority: 04.01.2023 KR 20230001322
(43) Date of publication of application: 10.07.2024
(73) Proprietor: Samsung Electronics Co., Ltd., Suwon-si, Gyeonggi-do 16677 (KR)
(72) Inventor: HYUN, Seungdam, 16678, Suwon-si, (KR); KIM, Kyunghun, 16678, Suwon-si, (KR); KIM, Sunho, 16678, Suwon-si, (KR); KIM, Hyungyung, 16678, Suwon-si, (KR); PARK, Kwangmin, 18448, Hwaseong-si, (KR); YANG, Seungyeul, 16678, Suwon-si, (KR); YON, Gukhyon, 18448, Hwaseong-si, (KR); LEE, Minhyun, 16678, Suwon-si, (KR); CHOI, Seokhoon, 16678, Suwon-si, (KR); HEO, Hoseok, 16678, Suwon-si, (KR)
(74) Representative: Elkington and Fife LLP

(56) References cited:
- US-A1- 2009 081 431
- MONZIO COMPAGNONI CHRISTIAN ET AL: "Reliability of NAND Flash Arrays: A Review of What the 2-D-to-3-D Transition Meant", IEEE TRANSACTIONS ON ELECTRON DEVICES, IEEE, USA, vol. 66, no. 11, 1 November 2019 (2019-11-01), pages 4504 - 4516, XP011755490, ISSN: 0018-9383, [retrieved on 20191028], DOI: 10.1109/TED.2019.2917785
- PATTANAIK SHREENU ET AL: "Enhancement of room temperature ferromagnetism in nanocrystalline Zr1-xMnxO2 by the suppression of monoclinic structure of zirconia", JOURNAL OF MAGNETISM AND MAGNETIC MATERIALS, ELSEVIER, AMSTERDAM, NL, vol. 494, 30 August 2019 (2019-08-30), XP085842031, ISSN: 0304-8853, [retrieved on 20190830], DOI: 10.1016/J.JMMM.2019.165768
- PENG YUE ET AL: "Nanocrystal-Embedded-Insulator (NEI) Ferroelectric Field-Effect Transistor Featuring Low Operating Voltages and Improved Synaptic Behavior", IEEE ELECTRON DEVICE LETTERS, IEEE, USA, vol. 40, no. 12, 1 December 2019 (2019-12-01), pages 1933 - 1936, XP011758405, ISSN: 0741-3106, [retrieved on 20191126], DOI: 10.1109/LED.2019.2947086

## Description

### FIELD OF THE INVENTION

The disclosure relates to a vertical NAND flash memory device.

### BACKGROUND OF THE INVENTION

As related art hard disks have been replaced by solid state drives (SSDs), a NAND flash memory device, which is a nonvolatile memory device, has been widely commercialized. Recently, a vertical NAND flash memory device in which a plurality of memory cells are stacked in a direction perpendicular to a substrate has been developed in accordance with the trend of compact size and high integration.

In a vertical NAND flash memory device, a charge transfer between memory cells may occur due to an increase in the number of stacked stages of memory cells and a decrease in the height of the memory cells, and such charge transfer may deteriorate the charge retention of the memory cells.

US 2009/081431 A1 describes a method for creating nanoscale formations. Namely, said patent document discloses a memory device wherein each cell comprises a charge trap layer, the charge trap layer comprising: an insulating matrix and ferroelectric nanoparticles in the insulating matrix.

Monzio Compagnoni Christian et al., "Reliability of NAND Flash arrays: A Review of What the 2-D-to-3-D Transition Meant"*,* describes what changed in the reliability of NAND Flash memory arrays after the paradigm shift in technology evolution determined by the transition from 2-D to 3-D integration schemes.

Pattanaik Shreenu et al., "Enhancement of room temperature ferromagnetism in nanocrystalline Zr1-xMnxO2 by the suppression of monoclinic structure of zirconia*",* describes that the bandgap of nanocrystalline samples decreases with the increase in Mn concentration.

### SUMMARY OF THE INVENTION

Provided is a vertical NAND flash memory device.

Additional aspects will be set forth in part in the description which follows and, in part, will be apparent from the description, or may be learned by practice of the presented embodiments of the disclosure.

According to an aspect of the disclosure, there is provided a vertical NAND flash memory device according to claim 1.

The charge trap material may include a fluorite-based material, a perovskite-based material, or a wurtzite-based material.

The fluorite-based material may include HfO2 or ZrO2.

The fluorite-based material may include a dopant.

The dopant may include at least one of Al, Ga, Co, Ni, Mg, In, La, Y, Nd, Sm, Er, Sr, Ba, Gd, Ge, N, and Si.

The fluorite-based material may include an anti-ferroelectric material having a tetragonal system structure or a ferroelectric material having an orthorhombic system structure.

The fluorite-based material may include nanocrystals having a grain size of about 1 nm to about 7 nm.

The perovskite-based material may include a material having a composition of ABO3, and where A and B may include metal elements.

The perovskite-based material may include at least one of PbZrO3, PbTiO3, BaTiO3, SrTiO3 and CaTiO3.

The wurtzite-based material may include AIN, GaN or InN.

The wurtzite-based material may include a dopant.

The matrix may include a paraelectric material.

The vertical NAND flash memory device may include a substrate, where each cell array of the plurality of cell arrays may be arranged perpendicularly to the substrate.

A channel hole extending in a direction perpendicular to the substrate may be inward relative to the channel layer.

The channel hole may be filled with a filling insulating layer.

The channel layer and the charge trap layer may have a cylindrical shape surrounding the channel hole.

The vertical NAND flash memory device may include a tunneling barrier layer provided between the channel layer and the charge trap layer.

The plurality of gate electrodes may be spaced apart from each other in the direction perpendicular to the substrate, and where each gate electrode of the plurality of gate electrodes surrounds the charge trap layer.

The vertical NAND flash memory device may include a blocking insulating layer provided between the charge trap layer and the plurality of gate electrodes.

According to an aspect of the disclosure, an electronic device may include a vertical NAND flash memory device including a plurality of cell arrays, where each cell array of the plurality of cell arrays may include a channel layer, a charge trap layer provided on the channel layer, the charge trap layer including a matrix including a dielectric and a charge trap material in the matrix and including nanocrystals, and a plurality of gate electrodes provided on the charge trap layer.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a diagram of a vertical NAND flash memory device according to an embodiment;
FIG. 2 is a cross-sectional view of a cell array illustrated in FIG. 1 according to an embodiment;
FIG. 3 is a diagram of a portion of a memory cell illustrated in FIG. 2 according to an embodiment;
FIG. 4A is a diagram of a relationship between an electric field E and polarization P applied to ferroelectric, according to an embodiment not forming part of the invention;
FIG. 4B is a diagram of a relationship between charges Q and energy U of the ferroelectric according to an embodiment not forming part of the invention;
FIG. 5A is a schematic diagram of a relationship between an electric field E and polarization P applied to anti-ferroelectric, according to an embodiment;
FIG. 5B is a diagram of a relationship between charges Q and energy U of the anti-ferroelectric according to an embodiment;
FIG. 6A is a band diagram illustrating a program operation of a memory cell having a charge trap layer with anti-ferroelectric nanocrystals (AFE-NC) according to an embodiment;
FIG. 6B is a band diagram illustrating a program operation of the memory cell having a charge trap layer without AFE-NC;
FIG. 6C is a band diagram illustrating an erase operation of the memory cell having a charge trap layer with AFE-NC according to an embodiment;
FIG. 6D is a band diagram illustrating an erase operation of the memory cell having a charge trap layer without AFE-NC according to an embodiment; and
FIG. 7 is a diagram of a device architecture applicable to an electronic device according to an embodiment.

### DETAILED DESCRIPTION

Reference will now be made in detail to embodiments, examples of which are illustrated in the accompanying drawings, where like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

The disclosure will now be described more fully with reference to the accompanying drawings, in which embodiments of the disclosure are shown. In the drawings, like reference numerals refer to like elements throughout and sizes of constituent elements may be exaggerated for convenience of explanation and the clarity of the specification. Also, embodiments described herein may have different forms and should not be construed as being limited to the descriptions set forth herein.

It will also be understood that when an element is referred to as being "on" or "above" another element, the element may be above, below, on the left, or on the right of the other element and in direct contact with the other element or other intervening elements may be present. The singular forms include the plural forms unless the context clearly indicates otherwise. It should be understood that, when a part "comprises" or "includes" an element, unless otherwise defined, other elements are not excluded from the part and the part may further include other elements.

The use of the terms "a" and "an" and "the" and similar referents are to be construed to cover both the singular and the plural. The steps of all methods described herein can be performed in any suitable order unless otherwise indicated herein or otherwise clearly contradicted by context, and are not limited to the described order.

Also, in the specification, the term "units" or "modules" denote units or modules that process at least one function or operation, and may be realized by hardware, software, or a combination of hardware and software.

Furthermore, the connecting lines, or connectors illustrated in the various figures presented are intended to represent exemplary functional relationships and/or physical or logical couplings between the various elements. It should be noted that many alternative or additional functional relationships, physical connections or logical connections may be present in a practical device.

The use of any and all examples, or exemplary language (e.g., "such as") provided herein, is intended merely to better illuminate the disclosure and does not pose a limitation on the scope of the disclosure unless otherwise claimed.

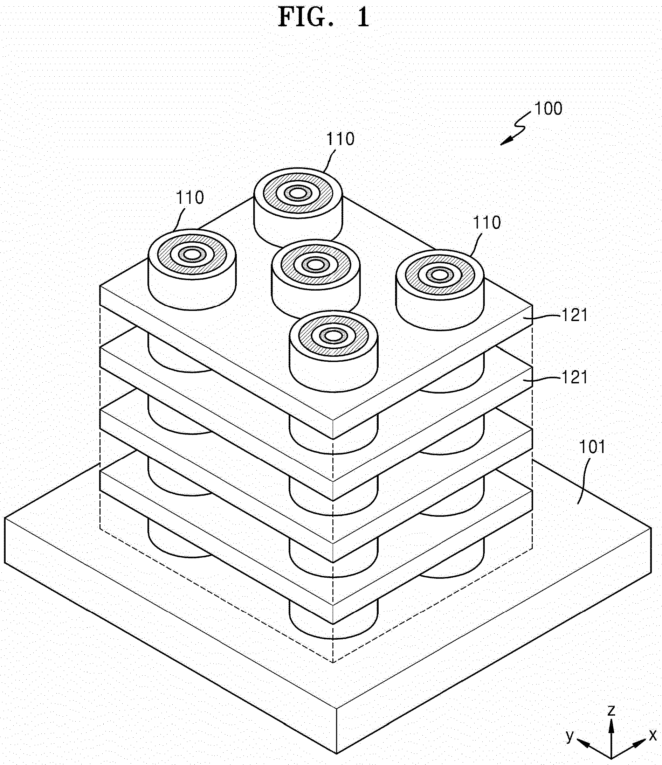

FIG. 1 is a diagram of a vertical NAND flash memory device according to an embodiment.

Referring to FIG. 1, the vertical NAND flash memory device 100 includes a plurality of cell arrays (e.g., cell arrays 110) arranged on a substrate 101. Each cell array 110 may be provided to extend in a direction perpendicular to the substrate 101 (z-axis direction in FIG. 1). The plurality of cell arrays may be arranged on the substrate 101 in various forms.

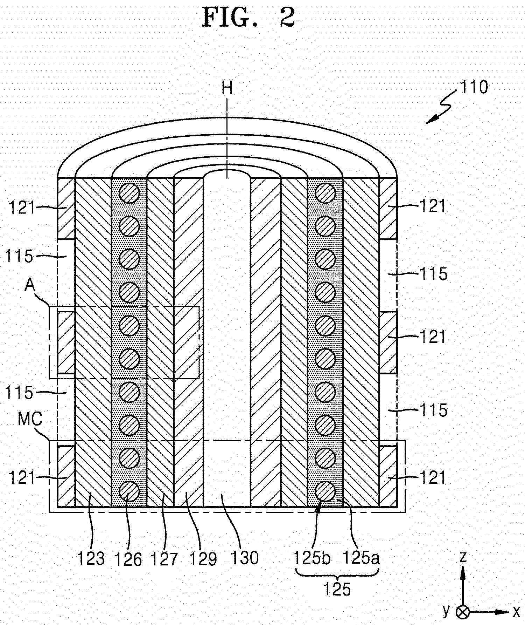

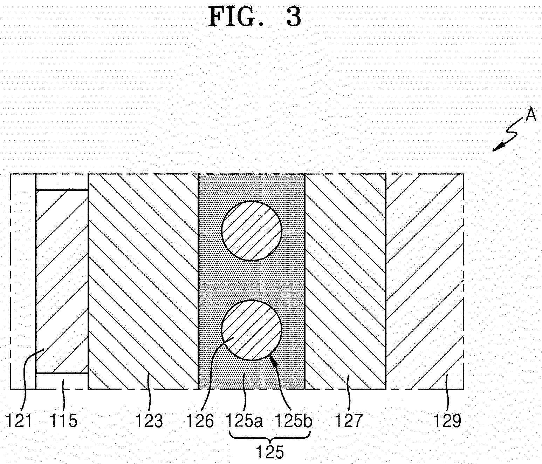

FIG. 2 is a cross-sectional view of a cell array illustrated in FIG. 1 according to an embodiment. FIG. 3 is a diagram of a portion of a memory cell illustrated in FIG. 2 according to an embodiment. That is, FIG. 2 illustrates a cross-section of each cell array 110 illustrated in FIG. 1, and FIG. 3 is an enlarged view of a major portion A of a memory cell MC illustrated in FIG. 2.

Referring to FIGS. 1 and 2, the cell array 110 includes a plurality of memory cells MC stacked in the direction perpendicular to the substrate 101 (z-axis direction). The cell array 110 may include a plurality of gate electrodes 121 spaced apart from each other and stacked in the direction perpendicular to the substrate 101. The cell array 110 may include a blocking insulating layer 123, a charge trap layer 125, a tunneling barrier layer 127, and a channel layer 129 that are sequentially provided inward relative to the gate electrodes 121 and parallel to the substrate 101. Each of the blocking insulating layer 123, the charge trap layer 125, the tunneling barrier layer 127, and the channel layer 129 may be provided to extend perpendicularly to the substrate 101 and may be shared by the plurality of memory cells MC.

Each memory cell MC may include a gate electrode 121, and the blocking insulating layer 123, the charge trap layer 125, the tunneling barrier layer 127, and the channel layer 129 that are provided to correspond to the gate electrode 121. A source and a drain may be provided in the channel layer 129 positioned in a lower portion and an upper portion of each memory cell MC, and a channel corresponding to the gate electrode 121 may be provided in the channel layer 129 between the source and the drain. When a voltage is applied to the gate electrode 121 of each memory cell MC, charges flowing between the source and the drain in the channel layer 129 corresponding to the gate electrode 121 may pass through the tunneling barrier layer 127 and captured in the charge trap layer 125 to thereby store information.

Interlayer insulating layers 115 and gate electrodes 121 are alternately stacked on the substrate 101 in the direction perpendicular to the substrate 101. Each interlayer insulating layer 115 and each gate electrode 121 may be provided parallel to the substrate 101. The substrate 101 may include various materials. For example, the substrate 101 may include a single crystal silicon substrate, a compound semiconductor substrate, or a silicon on insulator (SOI) substrate, but is not limited thereto. In addition, the substrate 101 may further include, for example, an impurity region formed by doping, an electronic element such as a transistor, or a periphery circuit for selecting and controlling memory cells storing data.

The gate electrode 121 controls a corresponding channel layer 129, and a word line may be electrically connected to the gate electrode 121. The gate electrode 121 may include, for example, a metal material having excellent electrical conductivity such as gold (Au), a metal nitride, impurity-doped silicon, or a two-dimensional conductive material. However, this is merely an example, and the gate electrode 121 may also include various other materials. The interlayer insulating layer 115 may act as a spacer layer for insulation between the gate electrodes 121. The interlayer insulating layer 115 may include, for example, silicon oxide or silicon nitride, but is not limited thereto.

A channel hole H is formed to pass through the interlayer insulating layers 115 and the gate electrodes 121 in the direction perpendicular to the substrate 101 (z-axis direction). The channel hole H may have a circular cross-section, for example.

The blocking insulating layer 123, the charge trap layer 125, the tunneling barrier layer 127, and the channel layer 129 are sequentially provided on an inner wall of the channel hole H. Each of the blocking insulating layer 123, the charge trap layer 125, the tunneling barrier layer 127, and the channel layer 129 may be formed to have a cylindrical shape extending in the direction perpendicular to the substrate 101. A filling insulating layer 130 may be provided inward relative to the channel layer 129 to fill the channel hole H. The filling insulating layer 130 may include, for example, silicon oxide or air, but is not limited thereto.

The channel layer 129 may include a semiconductor material. For example, the channel layer 129 may include, for example, Si, Ge, SiGe, Group III-V semiconductor, or the like. Also, the channel layer 129 may include, for example, an oxide semiconductor, a nitride semiconductor, a nitrogen oxide semiconductor, a two-dimensional (2D) semiconductor material, quantum dots, or an organic semiconductor. The oxide semiconductor may include, for example, InGaZnO, and the like, 2D semiconductor material may include, for example, transition metal dichalcogenide (TMD) or graphene, and the quantum dots may include colloidal quantum dots, a nanocrystal structure, and the like. However, this is only an example, and the embodiments are not limited thereto.

The channel layer 129 may further include a dopant. The dopant may include a p-type dopant or an n-type dopant. The p-type dopant may include, for example, a Group III element such as B, Al, Ga, and In, and the n-type dopant may include a Group V element, such as P, As, and Sb.

The blocking insulating layer 123, the charge trap layer 125, and the tunneling barrier layer 127 are provided between the gate electrodes 121 and the channel layer 129. The blocking insulating layer 123 is provided on the inner wall of the channel hole H to contact the interlayer insulating layers 11 an the gate electrodes 121. The blocking insulating layer 123 may include, for example, silicon oxide or metal oxide, but is not limited thereto. The tunneling barrier layer 127 includes a layer through which charges are tunneled, and may include, for example, silicon oxide or metal oxide, but is not limited thereto.

The charge trap layer 125 is provided between the blocking insulating layer 123 and the tunneling barrier layer 127. The charge trap layer 125 includes a matrix 125a and a charge trap material 125b provided inside the matrix 125a. The matrix 125a may include a different dielectric material from that of the charge trap material 125b. For example, the matrix 125a may include a paraelectric material. For example, the matrix 125a may include SiO₂, doped SiO₂, HfO₂, ZrO₂, and the like. HfO₂ or ZrO₂ may have a monoclinic crystal structure.

The charge trap material 125b may include a plurality of nanocrystals 126 dispersed in the matrix 125a. The nanocrystals 126 may include a ferroelectric ial, according to an example not forming part of the invention, or anti-ferroelectric material, according to the present invention.

A ferroelectric material has a spontaneous dipole (electric dipole) (e.g. spontaneous polarization) due to non-centrosymmetric charge distribution in a unit cell in a crystallized material structure. Ferroelectric materials have remnant polarization by dipoles even in the absence of an external electric field. In addition, the direction of polarization may be switched on a domain-by-domain basis by an external electric field.

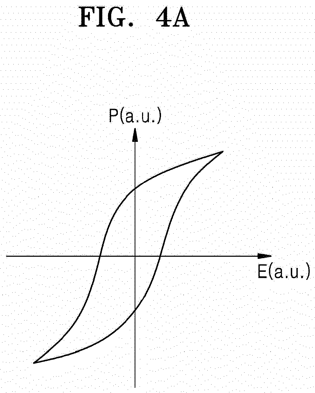

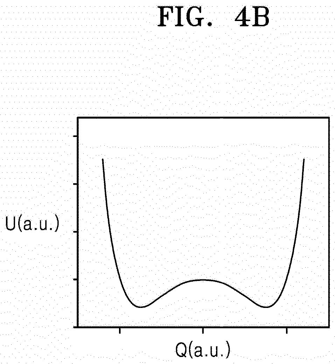

FIG. 4A is a diagram of a relationship between an electric field E and polarization P applied to ferroelectric, according to an example not forming part invention. FIG. 4B is a diagram of a relationship between charges Q and energy U of the ferroelectric according to an example not forming part of the present invention.

Referring to FIGS. 4A and 4B, the charge Q-vs-energy U graph of the ferroelectric has a well shape on both, left and right sides. The two well shapes correspond to two stable polarization states, and this graph shape denotes a hysteresis behavior.

An anti-ferroelectric material may include an array of electrical dipoles, but may have a remnant polarization of zero or close to zero. In the absence of an electric field, the directions of adjacent dipoles are reversed and polarization is canceled, and thus, the overall spontaneous and the remnant polarization may be zero or close to zero. However, polarization characteristics and switching characteristics may be exhibited in a state in which an external electric field is applied.

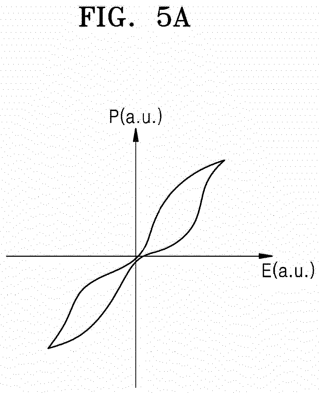

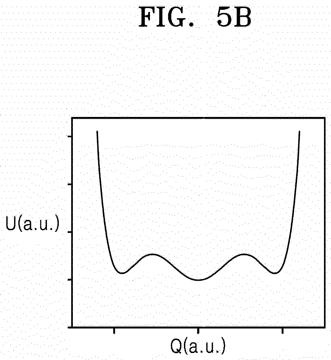

FIG. 5A is a schematic diagram of a relationship between an electric field E and polarization P applied to anti-ferroelectric, according to an embodiment. FIG. 5B is a diagram of a relationship between charges Q and energy U of the anti-ferroelectric according to an embodiment. Referring to FIGS. 5A and 5B, the charge Q-vs-energy U graph of the anti-ferroelectric has a different curve shape from that of the ferroelectric.

The charge trap material 125b may include a fluorite-based material, a perovskite-based material, or a wurtzite-based material. Fluorite-based materials may include, for example, undoped HfO₂ or ZrO₂. HfO₂ or ZrO₂ may have a crystal structure of a tetragonal system or an orthorhombic system. The tetragonal crystal structure may have anti-ferroelectricity, and the orthorhombic crystal structure may have ferroelectricity. Undoped HfO₂ has a stable tetragonal crystal structure, but may also have an orthorhombic crystal structure, depending on the grain size. Undoped ZrO₂ may have a stable tetragonal crystal structure. Undoped HfO₂ or ZrO₂ may include, for example, nanocrystals having a grain size of about 1 nm to about 3 nm, but is not limited thereto.

Fluorite-based materials may include, for example, HfO₂ or ZrO₂ including dopants. The dopants may include, for example, at least one of Al, Ga, Co, Ni, Mg, In, La, Y, Nd, Sm, Er, Sr, Ba, Gd, Ge, N, and Si. However, the above are only an example. HfO₂ or ZrO₂ including a dopant may have a tetragonal crystal structure having anti-ferroelectricity or an orthorhombic crystal structure having ferroelectricity, depending on the grain size and doping concentration. The smaller the grain size and the higher the doping concentration, the more stable is the tetragonal crystal structure, and the larger the grain size and the lower the doping concentration, the more stable is the orthorhombic crystal structure.

HfO₂ or ZrO₂ doped with a dopant may include nanocrystals having a larger grain size than the undoped HfO₂ or ZrO₂ described above. For example, HfO₂ or ZrO₂ doped with a dopant may have a grain size of about 4 nm to about 7 nm (for example, 4 nm to 5 nm), but is not limited thereto.

A dopant concentration may vary according to the type of dopant. For example, when the dopant is Si, a doping concentration thereof may be about 1 at% (atomic percent) to about 5 at%. However, the disclosure is not limited thereto.

Perovskite-based materials may include a material having a composition of ABO₃ (where A and B are metal elements). Perovskite-based materials may include, for example, at least one of PbZrO₃, PbTiO₃, BaTiO₃, SrTiO₃, and CaTiO₃. However, the disclosure is not limited thereto. Perovskite-based materials may have a tetragonal crystal structure having anti-ferroelectricity or an orthorhombic crystal structure having ferroelectricity, depending on the composition ratio of constituent elements. Wurtzite-based materials may include undoped AIN, GaN or InN or may include AIN, GaN or InN including a dopant.

As a method of forming the charge trap layer 125 including the matrix 125a including a dielectric and the charge trap material 125b including the nanocrystals 126 dispersed in the matrix 125a, spinodal decomposition or nucleation growth may be used. For example, when a ratio of HfO/(HfO+SiO) in a HfO-SiO solid solution is about 35 at% to about 95 at%, and heat treatment is performed at a temperature of about 1300 °C to about 1500 °C, by spinodal decomposition, HfO₂ nanocrystals doped with Si at about 3 at% to about 5 at% and a SiO₂ matrix doped with Hf at about 35 at% may be formed. The spinodal decomposition may occur when the formation energy (e.g., the Gibbs free-energy change (ΔG)) due to mixing of HfO₂ and SiO₂ is greater than 0 in a certain temperature range. Si-doped HfO₂ nanocrystals have an anti-ferroelectric tetragonal crystal structure and may have a grain size of about 3 nm to about 4 nm.

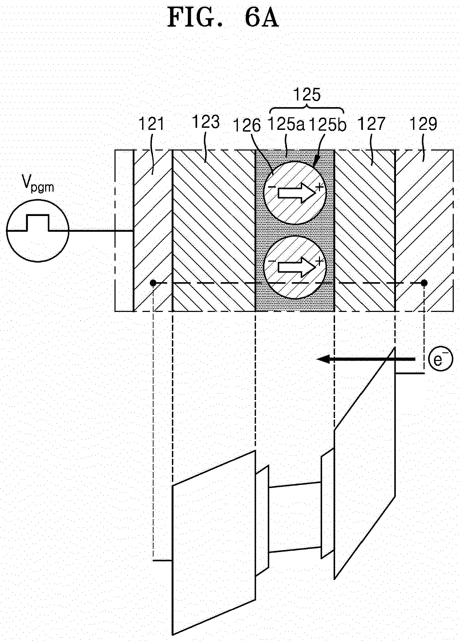

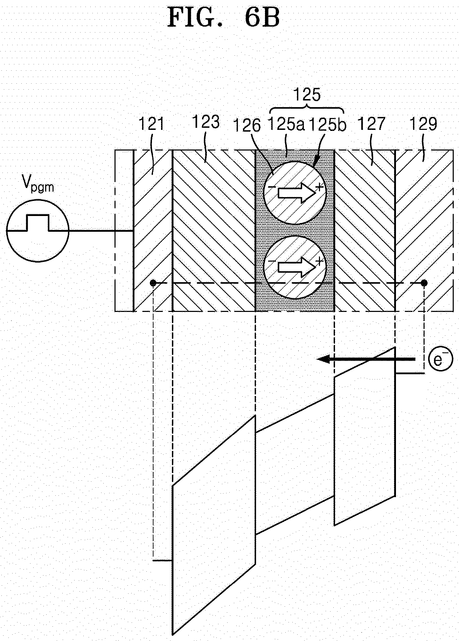

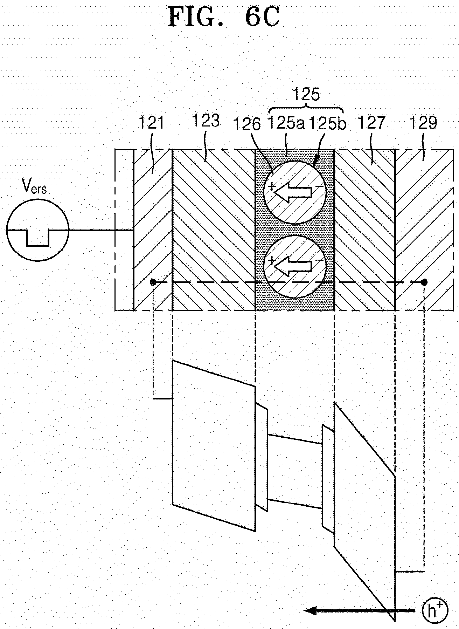

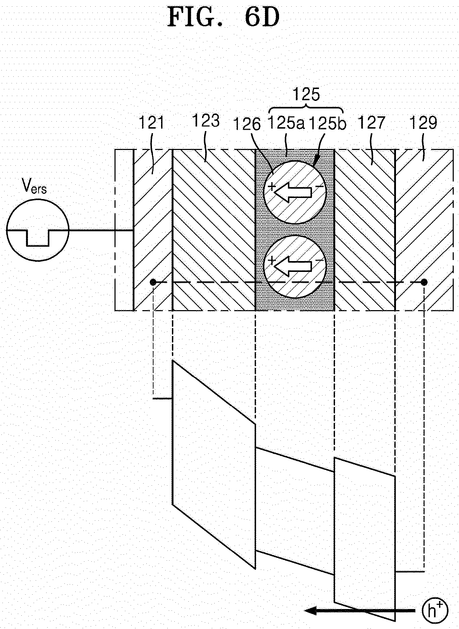

FIG. 6A is a band diagram illustrating a program operation of the memory cell MC illustrated in FIG. 3 having a charge trap layer with anti-ferroelectric nanocrystals (AFE-NC) according to an embodiment. FIG. 6B is a band diagram illustrating a program operation of the memory cell MC illustrated in FIG. 3 having a charge trap layer without AFE-NC according to an embodiment. FIG. 6C is a band diagram illustrating an erase operation of the memory cell MC illustrated in FIG. 3 having a charge trap layer with AFE-NC according to an embodiment. FIG. 6D is a band diagram illustrating an erase operation of the memory cell MC illustrated in FIG. 3 having a charge trap layer without AFE-NC according to an embodiment. FIGS. 6A and 6B illustrate a program operation of the memory cell MC illustrated in FIG. 3.

Referring to FIGS. 6A and 6B, when a positive (+) program voltage V_{pgm} is applied to the gate electrode 121 from the outside, polarization switching due to anti-ferroelectric or ferroelectric switching occurs in the nanocrystals 126 of the charge trap material 125b, and accordingly, a permittivity of the nanocrystals 126 rapidly increases. Thus, most of the program voltage V_{pgm} may be applied to the tunneling barrier layer 127. Moreover, positive and negative charges due to polarization in the nanocrystals 126 may further amplify an electric field applied to the tunneling barrier layer 127. Accordingly, electrons in the channel layer 129 may easily pass through the tunneling barrier layer 127 and be stored in the nanocrystals 126 of the charge trap material 125b. Since an external voltage required for electrons to pass through the tunneling barrier layer 127 is set, in the memory cell MC according to the embodiment, a program voltage may be lowered by the nanocrystals 126 having anti-ferroelectricity or ferroelectricity (e.g., as reflected in the band diagram of FIG. 6A versus the band diagram of FIG. 6B).

FIGS. 6C and 6D illustrates an erase operation of the memory cell MC illustrated in FIG. 3.

Referring to FIGS. 6C and 6D, when a negative (-) erase voltage Vₑᵣₛ is applied to the gate electrode 121 from the outside, polarization switching occurs in an opposite direction to that of the program operation in the nanocrystals 126 of the charge trap material 125b. Accordingly, the permittivity of the nanocrystals 126 increases rapidly, and most of the erase voltage Vₑᵣₛ may be applied to the tunneling barrier layer 127. Moreover, an electric field applied to the tunneling barrier layer 127 may be further amplified by the positive and negative charges of the polarization generated in the nanocrystals 126. Thus, holes in the channel layer 129 may easily pass through the tunneling barrier layer 127 and be stored in the nanocrystals 126 of the charge trap material 125b. Since an external voltage required for holes to pass through the tunneling barrier layer 127 is set, an erase voltage may be lowered by the nanocrystals 126 having anti-ferroelectricity or ferroelectricity, in the memory cell MC according to the embodiment (e.g., as reflected in the band diagram of FIG. 6C versus the band diagram of FIG. 6D).

As described above, in the vertical NAND flash memory device 100 according to an embodiment, the charge trap material 125b of the charge trap layer 125 may include the plurality of nanocrystals 126 having anti-ferroelectricity, according to the present invention, or ferroelectricity. according to an example not forming part of the invention, and accordingly, the program voltage and the erase voltage may be lowered, and a memory window may also be improved. In addition, as the nanocrystals 126 are separated from each other by the matrix 125a composed of a dielectric material in which a charge transfer hardly occurs, it is difficult for charges stored in the nanocrystals 126 to move between the memory cells MC, and thus, the data retention characteristics of the memory cell MC may also be improved.

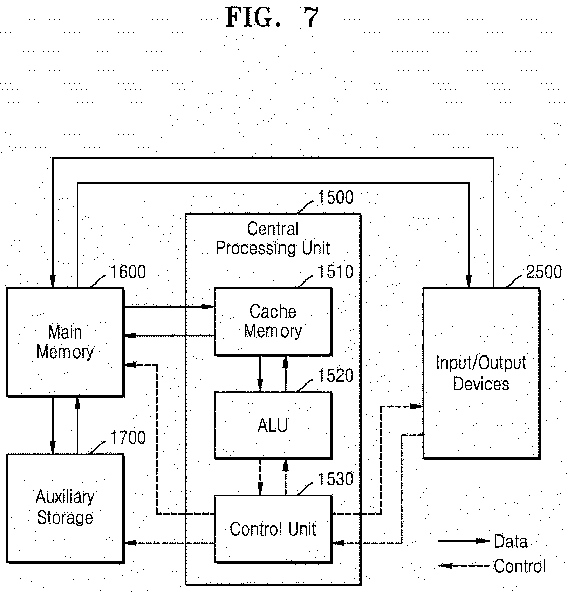

The vertical NAND flash memory device 100 described above may be used for data storage in various electronic devices. FIG. 7 is a diagram of a device architecture applicable to an electronic device according to an embodiment.

Referring to FIG. 7, a cache memory 1510, an arithmetic logic unit (ALU) 1520, and a control unit 1530 may configure a central processing unit (CPU) 1500, and the cache memory 1510 may include static random access memory (SRAM). Apart from the CPU 1500, a main memory 1600 and an auxiliary storage 1700 may be provided. The main memory 1600 may include a dynamic RAM (DRAM) device, and the auxiliary storage 1700 may include the vertical NAND flash memory device 100 described above. In some cases, the device architecture may be implemented in a form in which computing unit devices and memory unit devices are adjacent to each other in a single chip without distinguishing sub-units.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A vertical NAND flash memory device (100), comprising:
a plurality of cell arrays (110),
wherein each cell array of the plurality of cell arrays comprises:
a channel layer (129);
a charge trap layer (125) provided on the channel layer, the charge trap layer comprising:
a matrix (125a) comprising a dielectric; and
a charge trap material (125b) in the matrix and comprising anti-ferroelectric nanocrystals (126); and
a plurality of gate electrodes (121) provided on the charge trap layer.

2. The vertical NAND flash memory device of claim 1, wherein the charge trap material further comprises a fluorite-based material, a perovskite-based material, or a wurtzite-based material.

3. The vertical NAND flash memory device of claim 2, wherein the fluorite-based material comprises HfO₂ or ZrO₂.

4. The vertical NAND flash memory device of claim 3, wherein the fluorite-based material further comprises a dopant.

5. The vertical NAND flash memory device of claim 4, wherein the dopant comprises at least one of Al, Ga, Co, Ni, Mg, In, La, Y, Nd, Sm, Er, Sr, Ba, Gd, Ge, N, and Si.

6. The vertical NAND flash memory device of claim 3, wherein the fluorite-based material comprises an anti-ferroelectric material having a tetragonal system structure.

7. The vertical NAND flash memory device of claim 6, wherein the fluorite-based material comprises nanocrystals having a grain size of 1 nm to 7 nm.

8. The vertical NAND flash memory device of claim 2, wherein the perovskite-based material comprises a material having a composition of ABO₃, and
wherein A and B comprise metal elements, and optionally wherein the perovskite-based material comprises at least one of PbZrO₃, PbTiO₃, BaTiO₃, SrTiO₃ and CaTiO₃.

9. The vertical NAND flash memory device of any preceding claim when dependent on claim 2, wherein the wurtzite-based material comprises AIN, GaN or InN, and optionally wherein the wurtzite-based material further comprises a dopant.

10. The vertical NAND flash memory device of any preceding claim, wherein the matrix further comprises a paraelectric material.

11. The vertical NAND flash memory device of any preceding claim, further comprising a substrate,
wherein each cell array of the plurality of cell arrays is arranged perpendicularly to the substrate, and optionally wherein a channel hole extending in a direction perpendicular to the substrate is inward relative to the channel layer.

12. The vertical NAND flash memory device of claim 11, wherein the channel hole is filled with a filling insulating layer, and optionally wherein the channel layer and the charge trap layer have a cylindrical shape surrounding the channel hole.

13. The vertical NAND flash memory device of claim 12, further comprising a tunneling barrier layer provided between the channel layer and the charge trap layer.

14. The vertical NAND flash memory device of claim 12 or 13, wherein the plurality of gate electrodes are spaced apart from each other in the direction perpendicular to the substrate, and
wherein each gate electrode of the plurality of gate electrodes surrounds the charge trap layer, and optionally further comprising a blocking insulating layer provided between the charge trap layer and the plurality of gate electrodes.

15. An electronic device, comprising
a vertical NAND flash memory device according to any preceding claim.

## Patentansprüche

1. Vertikale NAND-Flash-Speichervorrichtung (100), umfassend:
eine Vielzahl von Zellarrays (110),
wobei jedes Zellarray aus der Vielzahl von Zellarrays Folgendes umfasst:
eine Kanalschicht (129);
eine Ladungsfallenschicht (125), die auf der Kanalschicht bereitgestellt ist, wobei die Ladungsfallenschicht Folgendes umfasst:
eine Matrix (125a), die ein Dielektrikum umfasst; und
ein Ladungsfallenmaterial (125b) in der Matrix und umfassend antiferroelektrische Nanokristalle (126); und
eine Vielzahl von Gate-Elektroden (121), die auf der Ladungsfallenschicht bereitgestellt ist.

2. Vertikale NAND-Flash-Speichervorrichtung nach Anspruch 1, wobei das Ladungsfallenmaterial ferner ein Material auf Fluoritbasis, ein Material auf Perowskitbasis oder ein Material auf Wurtzitbasis umfasst.

3. Vertikale NAND-Flash-Speichervorrichtung nach Anspruch 2, wobei das Material auf Fluoritbasis HfO₂ oder ZrO₂ umfasst.

4. Vertikale NAND-Flash-Speichervorrichtung nach Anspruch 3, wobei das Material auf Fluoritbasis ferner einen Dotierstoff umfasst.

5. Vertikale NAND-Flash-Speichervorrichtung nach Anspruch 4, wobei der Dotierstoff zumindest eines von Al, Ga, Co, Ni, Mg, In, La, Y, Nd, Sm, Er, Sr, Ba, Gd, Ge, N und Si umfasst.

6. Vertikale NAND-Flash-Speichervorrichtung nach Anspruch 3, wobei das Material auf Fluoritbasis ein antiferroelektrisches Material mit einer tetragonalen Systemstruktur umfasst.

7. Vertikale NAND-Flash-Speichervorrichtung nach Anspruch 6, wobei das Material auf Fluoritbasis Nanokristalle mit einer Korngröße von 1 nm bis 7 nm umfasst.

8. Vertikale NAND-Flash-Speichervorrichtung nach Anspruch 2, wobei das Material auf Perowskitbasis ein Material mit einer Zusammensetzung von ABO₃ umfasst, und
wobei A und B Metallelemente umfassen und wobei optional das Material auf Perowskitbasis zumindest eines von PbZrO₃, PbTiO₃, BaTiO₃, SrTiO₃ und CaTiO₃ umfasst.

9. Vertikale NAND-Flash-Speichervorrichtung nach einem vorhergehenden Anspruch, wenn abhängig von Anspruch 2, wobei das Material auf Wurtzitbasis AlN, GaN oder InN umfasst und wobei optional das Material auf Wurtzitbasis ferner einen Dotierstoff umfasst.

10. Vertikale NAND-Flash-Speichervorrichtung nach einem vorhergehenden Anspruch, wobei die Matrix ferner ein paraelektrisches Material umfasst.

11. Vertikale NAND-Flash-Speichervorrichtung nach einem vorhergehenden Anspruch, ferner umfassend ein Substrat,
wobei jedes Zellarray aus der Vielzahl von Zellarrays senkrecht zu dem Substrat angeordnet ist und wobei optional ein Kanalloch, das sich in einer Richtung senkrecht zu dem Substrat erstreckt, einwärts relativ zu der Kanalschicht ist.

12. Vertikale NAND-Flash-Speichervorrichtung nach Anspruch 11, wobei das Kanalloch mit einer Füllisolierschicht gefüllt ist, und wobei optional die Kanalschicht und die Ladungsfallenschicht eine zylindrische Form aufweisen, die das Kanalloch umgibt.

13. Vertikale NAND-Flash-Speichervorrichtung nach Anspruch 12, ferner umfassend eine Tunnelbarrierenschicht, die zwischen der Kanalschicht und der Ladungsfallenschicht bereitgestellt ist.

14. Vertikale NAND-Flash-Speichervorrichtung nach Anspruch 12 oder 13, wobei die Vielzahl von Gate-Elektroden in der Richtung senkrecht zu dem Substrat voneinander beabstandet ist, und
wobei jede Gate-Elektrode aus der Vielzahl von Gate-Elektroden die Ladungsfallenschicht umgibt und optional ferner umfassend eine blockierende Isolierschicht, die zwischen der Ladungsfallenschicht und der Vielzahl von Gate-Elektroden bereitgestellt ist.

15. Elektronische Vorrichtung, umfassend
eine vertikale NAND-Flash-Speichervorrichtung nach einem vorhergehenden Anspruch.

## Revendications

1. Dispositif de mémoire flash NAND verticale (100), comprenant :
une pluralité de réseaux de cellules (110),
chaque réseau de cellules de la pluralité de réseaux de cellules comprenant :
une couche de canal (129) ;
une couche de piégeage de charges (125) disposée sur la couche de canal, la couche de piégeage de charges comprenant :
une matrice (125a) comprenant un diélectrique ; et
un matériau de piégeage de charge (125b) dans la matrice et comprenant des nanocristaux antiferroélectriques (126) ; et
une pluralité d'électrodes de grille (121) disposées sur la couche de piégeage de charge.

2. Dispositif de mémoire flash NAND verticale de la revendication 1, ledit matériau de piégeage de charge comprenant en outre un matériau à base de fluorite, un matériau à base de pérovskite ou un matériau à base de wurtzite.

3. Dispositif de mémoire flash NAND verticale de la revendication 2, ledit matériau à base de fluorite comprenant HfO₂ ou ZrO₂.

4. Dispositif de mémoire flash NAND verticale de la revendication 3, ledit matériau à base de fluorite comprenant en outre un dopant.

5. Dispositif de mémoire flash NAND verticale de la revendication 4, ledit dopant comprenant au moins un parmi Al, Ga, Co, Ni, Mg, In, La, Y, Nd, Sm, Er, Sr, Ba, Gd, Ge, N et Si.

6. Dispositif de mémoire flash NAND verticale de la revendication 3, ledit matériau à base de fluorite comprenant un matériau anti-ferroélectrique possédant une structure de système tétragonal.

7. Dispositif de mémoire flash NAND verticale de la revendication 6, ledit matériau à base de fluorite comprenant des nanocristaux possédant une taille de grain de 1 nm à 7 nm.

8. Dispositif de mémoire flash NAND verticale de la revendication 2, ledit matériau à base de pérovskite comprenant un matériau possédant une composition de ABO₃, et
A et B comprenant des éléments métalliques, et éventuellement ledit matériau à base de pérovskite comprenant au moins un parmi PbZrO₃, PbTiO₃, BaTiO₃, SrTiO₃ et CaTiO₃.

9. Dispositif de mémoire flash NAND verticale d'une quelconque revendication précédente lorsqu'elle dépend de la revendication 2, ledit matériau à base de wurtzite comprenant AIN, GaN ou InN, et éventuellement ledit matériau à base de wurtzite comprenant en outre un dopant.

10. Dispositif de mémoire flash NAND verticale d'une quelconque revendication précédente, ladite matrice comprenant en outre un matériau paraélectrique.

11. Dispositif de mémoire flash NAND verticale d'une quelconque revendication précédente, comprenant en outre un substrat,
chaque réseau de cellules de la pluralité de réseaux de cellules étant agencé perpendiculairement au substrat, et éventuellement un trou de canal s'étendant dans une direction perpendiculaire au substrat étant vers l'intérieur par rapport à la couche de canal.

12. Dispositif de mémoire flash NAND verticale de la revendication 11, ledit trou de canal étant rempli d'une couche isolante de remplissage, et éventuellement ladite couche de canal et ladite couche de piégeage de charge possédant une forme cylindrique entourant ledit trou de canal.

13. Dispositif de mémoire flash NAND verticale de la revendication 12, comprenant en outre une couche barrière à effet tunnel disposée entre la couche de canal et la couche de piégeage de charge.

14. Dispositif de mémoire flash NAND verticale de la revendication 12 ou 13, ladite pluralité d'électrodes de grille étant espacées les unes des autres dans la direction perpendiculaire au substrat, et
chaque électrode de grille de la pluralité d'électrodes de grille entourant la couche de piégeage de charge, et éventuellement comprenant en outre une couche isolante de blocage disposée entre la couche de piégeage de charge et la pluralité d'électrodes de grille.

15. Dispositif électronique, comprenant un dispositif de mémoire flash NAND verticale selon une quelconque revendication précédente.
